## Europäisches Patentamt
## European Patent Office
## Office européen des brevets

Veröffentlichungsnummer: **0 280 261**

**A2**

(12) **EUROPÄISCHE PATENTANMELDUNG**

(21) Anmeldenummer: 88102662.9

(51) Int. Cl.⁴: **G01R 33/06**

(22) Anmeldetag: 24.02.88

(30) Priorität: 27.02.87 DE 3706306

(43) Veröffentlichungstag der Anmeldung:
31.08.88 Patentblatt 88/35

(84) Benannte Vertragsstaaten:
BE DE FR GB IT SE

(71) Anmelder: **Standard Elektrik Lorenz Aktiengesellschaft**
**Lorenzstrasse 10**
**D-7000 Stuttgart 40(DE)**

(72) Erfinder: **Löwel, Helmut**
**Preysingstrasse 6**
**D-8500 Nürnberg(DE)**

(74) Vertreter: **Hösch, Günther, Dipl.-Ing. et al**
**Standard Elektrik Lorenz AG Patent- und**
**Lizenzwesen Postfach 30 09 29**
**D-7000 Stuttgart 30(DE)**

(54) Schaltung zur Gewinnung eines temperaturunabhängigen Rechtecksignals aus einem Messsignal.

(57) Bei einer Schaltung zur Gewinnung eines temperaturunabhängigen Rechtecksignals aus einem Meßsignal, das von einem magnetfeldabhängigen Widerstand abgegriffen wird, der einem Magnetfeld wechselnder Richtung ausgesetzt ist und an dem das aus einem Gleich-und Wechselspannungsanteil bestehende Meßsignal ansteht, werden eine steuerbare Impedanz (6), ein Zeitglied mit relativ großer Zeitkonstante und Operationsverstärker mit Feldeffekttransistor-Eingängen verwendet. Hierdurch können alle Bauteile sehr klein gehalten werden und daher ein kompakter Aufbau gegebenenfalls in einem einzigen gemeinsamen Gehäuse erreicht werden.

Fig. 1

EP 0 280 261 A2

## Schaltung zur Gewinnung eines temperaturunabhängigen Rechtecksignals aus einem Meßsignal.

Die vorliegende Erfindung bezieht sich auf eine Schaltung zur Gewinnung eines temperaturunabhängigen Rechtecksignals aus einem Meßsignal gemäß dem Oberbegriff des Anspruchs 1.

Eine Schaltung und Signalformung eines Steuersignals einer aus vier magnetfeldabhängigen Widerständen bestehenden Brückenschaltung ist aus der Zeitschrift "Elektronik", Heft 10, vom 17.05.1985, Seiten 99 bis 101, bekannt. Dort ist auf Seite 100 als Signalverstärker ein Operationsverstärker und als Impulsformer ein als Schmitt-Trigger geschalteter Operationsverstärker verwendet. Die Versorgungsspannung wird dort als konstant vorausgesetzt und eine Temperaturkompensation wird durch einen Widerstand mit positivem Temperaturkoeffizienten über einen weiteren Verstärker sowie über einen zusätzlichen Spannungsteiler vorgenommen. Weiterhin liegen in den Zuleitungen zum Signalverstärker je ein Widerstand, um eine störende Temperaturabhängigkeit der Verstärkung zu beseitigen. Die bekannte Schaltung erfordert wenigstens vier Anschlüsse, nämlich je zwei für die Versorgungsspannung und je zwei für das Ausgangssignal.

Mit der vorliegenden Erfindung soll die Aufgabe gelöst werden, den Schaltungsaufwand zu reduzieren und trotzdem eine hohe Empfindlichkeit und stabilisierte Ausgangsgröße der Schaltung zu erhalten.

Gelöst wird diese Aufgabe durch die im Kennzeichen des Anspruchs 1 angegebenen Merkmale. Hierdurch wird das Meßsignal in einen entsprechend zeitlich veränderbaren Strom im zweiten Spannungsteiler umgewandelt und die Potentialverschiebung am Teilerpunkt desselben zur Stabilisierung der Betriebsspannung des ersten Spannungsteilers und zur Erzeugung des Rechtecksignals abgenommen. Dadurch sind nur wenige Bauteile noch notwendig. Diese können zu einer baulichen Einheit zusammengefaßt werden, wobei außer dem Masseanschluß zwei Leitungen, nämlich lediglich eine Zuleitung für die Versorgungsspannung und eine Ableitung für das Ausgangssignal, erforderlich sind.

Weitere vorteilhafte Einzelheiten der Erfindung sind nachfolgend anhand eines in der Zeichnung veranschaulichten Ausführungsbeispiels beschrieben.

Es zeigen:

Fig. 1 ein Schaltbild mit zwei magnetfeldabhängigen Widerständen,

Fig. 2 eine Anordnungsmöglichkeit der beiden magnetfeldabhängigen Widerstände zueinander und relativ zu einer Zahnung und

Fig. 3 ein Diagramm mit der verstärkten Meßspannung und dem daraus abgeleiteten Ausgangssignal.

Mit 1 ist ein erster Spannungsteiler bezeichnet, der aus einem magnetfeldabhängigen Widerstand 2 und einem mit diesem in Reihe liegenden zweiten magnetfeldabhängigen Widerstand 3 oder einem ohmschen Widerstand besteht. Der Spannungsteiler ist einseitig nach Masse geschaltet. Der Teilerpunkt 4 des ersten Spannungsteilers 1 ist an eine Steuerelektrode 5 einer als temperaturkompensierte steuerbare Impedanz dienenden, mit der Anode an Masse liegenden steuerbaren Zenerdiode 6 angeschlossen. Bei einem Ausführungsbeispiel wurde der Typ TL 431 benutzt. Letztere bildet mit einem an der Versorgungsspannung $U_V$ liegenden Widerstand 7 einen zweiten Spannungsteiler 8. Der Teilerpunkt 9 desselben ist über einen Widerstand 10 an den positiven Eingang 11 eines als Impedanzwandler geschalteten Operationsverstärkers 12 angeschlossen. Vom Eingang 11 ist außerdem ein Kondensator 13 nach Masse geschaltet. Dieser bildet mit dem Widerstand 10 ein R-C-Zeitglied, dessen Zeitkonstante wesentlich größer gewählt ist als die Periodendauer der niedrigsten zu erwartenden Frequenz des Wechselspannungsanteils $U_W$ des Meßsignals $U_M$ am Teilerpunkt 4 des ersten Spannungsteilers 1. Als Operationsverstärker werden solche verwendet, die einen Feldeffekt-Transistor-Eingang aufweisen, so daß ein sehr hoher Eingangswiderstand erhalten wird. Zur Erzielung einer hohen Zeitkonstante z.B. von einer Sekunde und mehr wird daher nur eine kleine Kapazität für den Kondensator 13 benötigt, da der Widerstand 10 sehr hochohmig ausgeführt werden kann.

Der Ausgang 14 des Impedanzwandler-Operationsverstärkers 12 ist an seinen eigenen negativen Eingang 15 rückgekoppelt und außerdem an den negativen Eingang 16 eines zweiten als Komparator geschalteten Operationsverstärkers 17 angeschlossen. Das am Ausgang 14 anstehende stabilisierte Potential des Operationsverstärkers 12 ist die Betriebsspannung $U_B$ für den ersten Spannungsteiler 1.

Der positive Eingang 18 des Komparator-Operationsverstärkers 17 ist über einen Widerstand 19 an den Teilerpunkt 9 des zweiten Spannungsteilers 8 angeschlossen und über einen Kopplungswiderstand 20 mit seinem eigenen Ausgang 21 verbunden.

Die Wirkungsweise dieser Schaltung ist folgende:

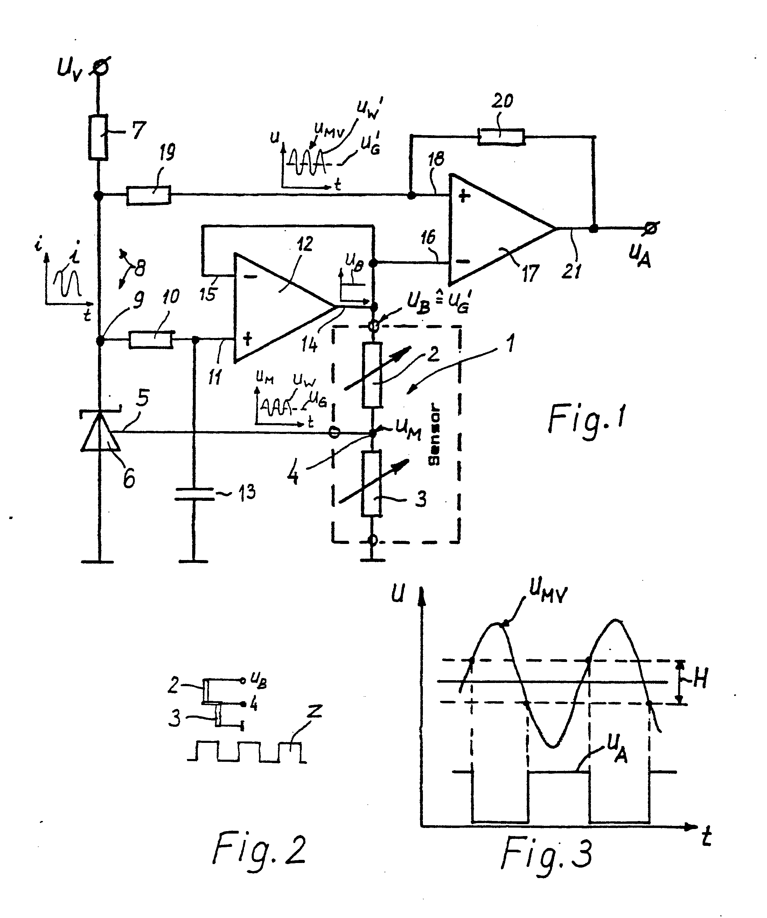

Die beiden magnetfeldabhängigen Widerstände 2 und 3 bewegen sich relativ zu einem ferromagnetischen Zahnrad oder einer Zahnstange mit den Zähnen Z einer konstanten Zahnbreite und mit geeignetem Zahnabstand. Dies ist in der Prinzipskizze der Fig. 2 dargestellt. Das Zahnrad oder die Zahnstange ist in an sich bekannter Weise magnetisiert oder dem bzw. den magnetfeldabhängigen Widerständen 2, 3 ist ein Permanentmagnet zugeordnet, dessen Magnetfeld die magnetfeldabhängigen Widerstände durchsetzt und dessen Richtung in den magnetfeldabhängigen Widerständen durch ein äußeres ferromagnetisches Teil verändert wird, so daß sich der Widerstandswert derselben ebenfalls verändert. Beim Vorbeibewegen der Zähne Z an den um eine halbe Zahnbreite gegeneinander versetzt angeordneten magnetfeldabhängigen Widerständen 2, 3 (vgl. Fig. 2) erhöht sich der Widerstandswert des einen magnetfeldabhängigen Widerstandes und erniedrigt sich derjenige des anderen und umgekehrt periodisch von einem z.B. gleichen Normwert aus. Hierdurch erhält man am Teilerpunkt 4 des ersten Spannungsteilers 1 ein Meßsignal $U_M$, das aus einem mit einem Wechselspannungsanteil $U_W$ überlagerten Gleichspannungsanteil $U_G$ besteht. Dieses Meßsignal ist in Fig. 1 über der Strecke zwischen Teilerpunkt 4 und Steuerelektrode 5 eingezeichnet.

Als steuerbare Zenerdiode 6 ist, wie erwähnt, bei einem Ausführungsbeispiel der integrierte Schaltkreis TL 431 mit interner Temperaturkompensation und einer Referenzsteuerspannung von 2,5 V benutzt worden. Bei gleichen magnetfeldabhängigen Widerständen 2 und 3 ist die Betriebsspannung $U_B$ daher 5 V. In betriebsbereitem Zustand stehen daher an der Steuerelektrode 5 die genannten 2,5 V an.

Wird nun der Widerstandswert der magnetfeldabhängigen Widerstände 2, 3 durch Relativbewegung zu den Zähnen Z verändert, so wird die Meßspannung $U_M$ erzeugt. Letztere steuert die steuerbare Zenerdiode 6 derart, daß bei fallendem Potential am Teilerpunkt 4 des ersten Spannungsteilers 1 das Potential am Teilerpunkt 9 des zweiten Spannungsteilers 8 ansteigt und umgekehrt.

Ohne den Kondensator 13 und den Widerstand 10 würde sich diese Änderung als Änderung der Betriebsspannung $U_B$ derart bemerkbar machen, daß das Potential am Teilerpunkt 4 des ersten Spannungsteilers 1 2,5 V annehmen würde. Durch die große Zeitkonstante des R-C-Gliedes aus Kondensator 13 und Widerstand 10 im Verhältnis zu der Periodendauer des Wechselspannungsanteils $U_W$ des Meßsignals $U_M$ und der hochohmigen Eingänge der Operationsverstärker 12 und 17 kommt es nicht zur Ausregelung, sondern zu einer erheblichen Impedanzänderung der steuerbaren Zenerdiode 6 und der daraus folgenden Stromänderung im zweiten Spannungsteiler 8 sowie der entsprechenden Änderung des Potentials am Teilerpunkt 9 des zweiten Spannungsteilers 8, das als verstärktes Meßsignal $U_{MV}$ abgreifbar ist. Folglich bleibt auch die Betriebsspannung $U_B$ konstant und sie enthält praktisch keine Wechselspannungsanteile. Die Betriebsgleichspannung $U_B$ liegt auch am negativen Eingang 16 des Komparator-Operationsverstärkers 17. Da an dessen positivem Eingang 18 der Gleich-und Wechselspannungsanteil $U_W'$ und $U_G'$ anstehen, vergleicht dieser die Meßspannung $U_{MV}$ mit dem Gleichspannungsanteil $U_G'$. Der Komparator-Operationsverstärker 17 - schaltet daher entsprechend der durch die Widerstände 19 und 20 gewählten Hysterese H ab einem bestimmten Spannungswert oberhalb des Gleichspannungsanteils auf einen negativen Pegel und ab einer entsprechend unterhalb liegenden Spannungswert auf einen positiven Pegel. Diese Schaltungszustände sind in Fig. 3 im Prinzip dargestellt. Auf diese Weise wird eine relativ exakte stabile, insbesondere temperaturstabilisierte Rechteck-Ausgangsspannung $U_A$ erzeugt. Durch die Verwendung von Operationsverstärkern mit Feldeffekttransistoreingängen kann der Kondensator sehr klein gehalten werden, da ein sehr hochohmiger Widerstand 10, z.B. in der Größenordnung von 10 MOhm bis zu einigen 10 MOhm, verwendet werden kann. Zur Realisierung einer Zeitkonstante von 1 Sekunde kann daher z.B. ein Kondensator von 100 nF verwendet werden. Hierdurch kann ein sehr kompakter Aufbau der Schaltung realisiert werden und die gesamte Schaltung, also einschließlich Sensor, Impedanzwandlerstufe, Impulsformer etc., kann in einem kleinen Gehäuse untergebracht werden. Als Anschlüsse werden außer einem Massekontakt lediglich zwei Zuleitungen benötigt.

## Ansprüche

1. Schaltung zur Gewinnung eines temperaturunabhängigen Rechtecksignals aus einem Meßsignal, das von einem magnetfeldabhängigen Widerstand abgegriffen wird, der einem Magnetfeld wechselnder Richtung ausgesetzt ist und an dem das aus einem Gleich-und Wechselspannungsteil bestehende Meßsignal ansteht, **dadurch gekennzeichnet**, daß der magnetfeldabhängige Widerstand (2 und/oder 3) mit einem weiteren Widerstand (3 bzw. 2) einen ersten Spannungsteiler (1) bildet, dessen Teilerpunkt (4) mit dem Steuereingang (5) einer temperaturkompensierten steuerbaren Impedanz (6) verbunden ist, die mit einem an der Versorgungsspannung ($U_V$) liegenden Widerstand (7) einen zweiten Spannungsteiler (8) bildet, daß der Teilerpunkt (9) des zweiten Spannungsteilers (8) über einen Widerstand (10) eines R-C-Zeitgliedes (10, 13) am positiven Eingang (11) eines als Impedanzwandler geschalteten Operationsverstärkers (12) mit Feldeffekt-Transistor-Eingängen, von dem aus der Kondensator (13) des R-C-Gliedes (10, 13) nach Masse geschaltet ist, angeschlossen ist und das Ausgangspotential ($U_A$) des Ausgangs (14) des Impedanzwandler - Operationsverstärkers (12) die Betriebsspannung ($U_B$) des ersten Spannungsteilers (1) bildet, die sowohl an den negativen Eingang (15) des Impedanzwandler-Operationsverstärkers (12) als auch den negativen Eingang (16) eines zweiten, als Komparator geschalteten Operationsverstärkers (17) angeschlossen ist und der positive Eingang (18) des Komparator-Operationsverstärkers (17) über einen Widerstand (19) am Teilerpunkt (9) des zweiten Spannungsteilers (8) und über einen Kopplungswiderstand (20) mit seinem eigenen Ausgang (21) verbunden ist, und daß die Zeitkonstante des R-C-Gliedes (10, 13) wesentlich größer ist als die Periodendauer der kleinsten Frequenz des Wechselspannungsanteils ($U_W$) des Meßsignals ($U_M$).

2. Schaltung nach Anspruch 1, dadurch gekennzeichnet, daß die steuerbare Impedanz (6) eine steuerbare Zenerdiode ist.

3. Schaltung nach Anspruch 1 oder 2, dadurch gekennzeichnet, daß alle Bauteile, also erster Spannungsteiler (1) mit wenigstens einem magnetfeldabhängigen Widerstand (2 und/oder 3), zweiter Spannungsteiler (8) mit der steuerbaren Impedanz (6), Zeitglied (10, 13), Impedanzwandler (12) und Komparator (17) in einem einzigen Gehäuse untergebracht sind.

Fig.1

Fig.2

Fig.3